# EUROPÄISCHE PATENTSCHRIFT

(11) **EP 0 283 546 B1**
(45) Veröffentlichungstag und Bekanntmachung des Hinweises auf die Patenterteilung: **14.07.1993**
(21) Anmeldenummer: 87104580.3
(22) Anmeldetag: 27.03.1987
(51) Int. Cl.: H01L 21/48, G03F 1/00, G03F 7/00, H01L 21/66

(54) **Verfahren zum Herstellen beliebig geformter mikromechanischer Bauteile aus planparallelen Platten aus Polymermaterial oder beliebig geformter Duchführungsöffnungen in denselben**
Method for producing micromechanical components of any form from plane parallel polymer plates or via holes therein
Procédé pour la fabrication de composants micromécaniques, de n'importe quelle forme, à partir de plaques plans parallèles en polymère, et des traversées dans celles-ci

(43) Veröffentlichungstag der Anmeldung: 28.09.1988
(73) Patentinhaber: IBM DEUTSCHLAND GMBH, D-70569 Stuttgart (DE); International Business Machines Corporation, Armonk, N.Y. 10504 (US)
(72) Erfinder: Bartha, Johann, Dr., D-7032 Sindelfingen (DE); Bayer, Thomas, D-7032 Sindelfingen (DE); Greschner, Johann, Dr., D-7401 Pliezhausen 1 (DE); Wittlinger, Jürgen, D-7030 Böblingen (DE)
(74) Vertreter: Mönig, Anton, Dipl.-Ing.

(56) Entgegenhaltungen:
- EP-A- 0 072 673
- EP-A- 0 147 127
- EP-A- 0 198 215
- EP-A- 0 199 940
- DE-A- 2 810 054
- US-A- 4 566 184

## Beschreibung

Die Erfindung betrifft ein Verfahren zum Herstellen beliebig geformter mikromechanischer Bauteile aus planparallelen Platten aus Polymermaterial oder beliebig geformter Durchführungsöffnungen in denselben. Sie findet Anwendung im Rahmen der Packungstechnologie für hochleistungsfähige Computer, insbesondere bei der Herstellung von Durchführungsöffnungen mit Durchmessern < etwa 0.5 mm in relativ dicken Platten aus Polymermaterial.

Die ständige Vergrößerung des Integrationsgrades auf Halbleiterchips erfordert, daß die Signalwege zwischen den einzelnen Schaltungen so kurz wie eben nur möglich gehalten werden. Dieses Ziel läßt sich erreichen, wenn möglichst viele Chips auf einem einzelnen Mehrschichtkeramikträger untergebracht und miteinander verbunden werden können. Die höhere Packungsdichte auf den Mehrschichtkeramikträgern ihrerseits erfordert auch eine höhere Dichte in der sog. zweiten Packungsebene der Leiterplatten. Derzeit werden beispielsweise bis zu zwanzig Stromversorgungs- und Signalebenen in einer einzelnen Leiterplatte untergebracht, wodurch sich die Komplexität der Platte erhöht und die Anzahl der in die glasfaserverstärkten Epoxidlaminate zu bohrenden Löcher auf über 40 000 anwächst.

Auf die Mehrschichtkeramikträger, welche auf die Leiterplatten aufgesteckt werden, können, bei einer Kantenlänge von 150 mm und 33 Lagen, jeweils bis zu 118 Halbleiterchips aufgebracht werden.

Eine Anwendung der Erfindung, welche für die zuvor beschriebene Packungstechnologie von großer Bedeutung ist und bei der Durchführungsöffnungen in Polymersubstrate eingebracht werden müssen, ist die Herstellung von Führungsplatten für feine Metalldrähte beim Bau elektrischer Testköpfe. Mit diesen Testköpfen können in einem elektrischen Test alle Anschlußpunkte für Chips auf Mehrschichtkeramikträgern auf Unterbrechungen und Kurzschlüsse geprüft werden. Bei diesem Test werden Drähte aus gut leitendem, federndem Material in Richtung ihrer Achse auf die zu testenden Punkte der Mehrschichtkeramikträger gedrückt. Die Drähte wurden bisher in großen Abständen durch Führungsplatten geführt. Die Herstellung der Durchführungsöffnungen für die Drähte in den Führungsplatten erfolgte bisher durch mechanisches Bohren. Das Bohren der Löcher mit einem Durchmesser von etwa 125 µm in Platten von etwa 0.5 mm Dicke erforderte dabei, wegen der hohen Präzision der Lochpositionen, ein sehr zeitaufwendiges Einzellochbohren. Beispiele für Testköpfe bisheriger Bauart sind in der Deutschen Patentschrift DE-PS 23 64 786 und in den Europäischen Patentschriften EP-B 0 130 350 und EP-B 0 165 331 beschrieben.

Da zukünftige Mehrschichtkeramikprodukte, bedingt durch eine erhöhte Packungsdichte, kleinere Kontaktflächen aufweisen, welche außerdem noch unterhalb der Substratoberfläche liegen können und zwischen denen zusätzlich Leiterzüge angeordnet sind, können die bisher bekannten Testköpfe nicht mehr zum Testen verwendet werden. Es müssen vielmehr Testköpfe mit wesentlich geringeren Durchmessern und Abständen der Kontaktierungsdrähte verwendet werden. Damit der erforderliche Kontaktdruck und Z-Höhenausgleich auch mit dünneren Drähten erzielt werden kann, mußte ein neues Drahtführungskonzept verwirklicht werden. Testköpfe für die zukünftigen Mehrschichtkeramikprodukte werden deshalb aus bis zu 30 Führungsplatten von 1 mm Dicke aufgebaut und können bis zu 100 000 Löcher je Testkopf enthalten, was bedeutet, daß beim Bau eines solchen Testkopfes mit 30 Führungsplatten drei Millionen einzelne Löcher gebohrt werden müßten. Mit mechanischem Bohren wäre dies sehr zeitaufwendig, und außerdem gelangt man bei einem Lochdurchmesser von etwa 0.1 mm bei einer zu durchbohrenden Plattendicke von 1 mm auch technisch an die Grenze des mechanischen Bohrens.

Darüberhinaus erfordern zukünftige Mehrschichtkeramikprodukte aber noch feinere Dimensionen der Führungsöffnungen, und es müssen nicht nur runde Durchführungsöffnungen sondern auch Langlöcher hergestellt werden. Es sollte auch jede beliebig geformte Öffnung hergestellt werden können. Dies ist mit mechanischem Bohren nicht mehr realisierbar.

Außer dem Einbringen von Durchführungsöffnungen in planparallele Platten wäre auch die Herstellung mikromechanischer Bauteile aus solchen Platten erwünscht.

Aufgabe der Erfindung ist deshalb ein Verfahren zum Herstellen beliebig geformter mikromechanischer Bauteile oder beliebig geformter Durchführungsöffnungen in planparallelen Substraten aus Polymermaterial, das aus der Halbleitertechnologie bekannte Verfahrensschritte anwendet.

Die Aufgabe der Erfindung wird gelöst durch ein Verfahren gemäß Patentanspruch 1.

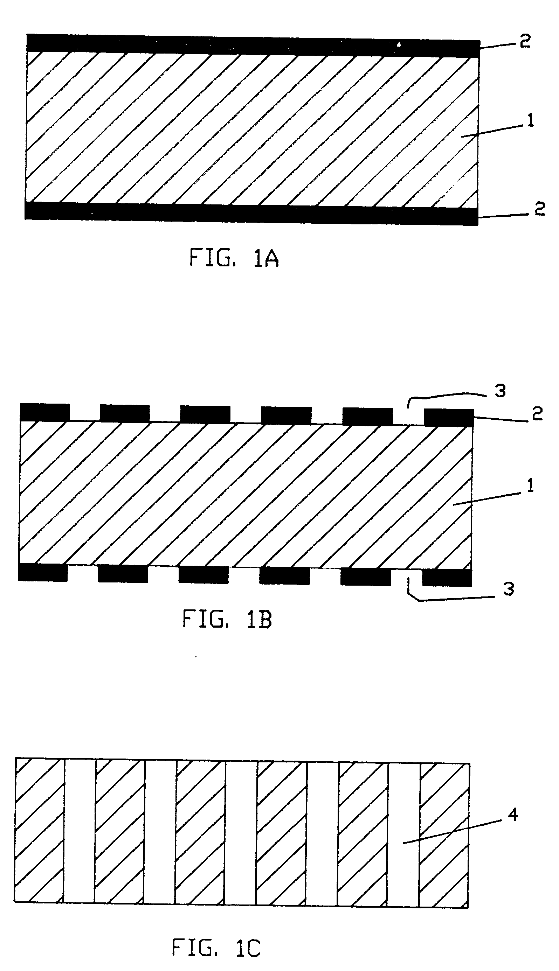

Das Verfahren der Erfindung gestattet das Strukturieren von Platten aus Polyoxymethylenhomo- oder Copolymerisaten. Es können auch mikromechanische Bauteile jeder gewünschten Form aus solchen Platten herausgearbeitet oder Öffnungen beliebiger Form in diese eingebracht werden. Überraschenderweise hat sich gezeigt, daß in Platten aus Polyoxymethylenhomo- oder Copolymerisaten mit Schichtdicken von etwa 0.1 bis 2 mm, vorzugsweise von etwa 0.5 bis 1 mm, Durchführungsöffnungen mit vertikalen Seitenwänden und mit vorgegebenen Positionstoleranzen besonders gut eingebracht werden können. Deshalb wird das Verfahren gemäß der Erfindung in der Beschreibung im Detail anhand des Ausführungsbeispiels und der Figuren 1 bis 5 näher erläutert.

Im einzelnen stellen dar:
- Fig. 1: (A bis C) Querschnittsdarstellungen eines Verfahrens zur Herstellung von Führungsplatten aus Polyoxymethylen;
- Fig. 2: ein Querschnitt einer Durchführungsöffnung in vergrößerter Darstellung nach dem reaktiven Ionenätzen;
- Fig. 3: (A und B) SEM(Rasterelektronenmikroskop)Aufnahmen von Löchern, welche in Polyoxymethylenplatten geätzt wurden;
- Fig. 4: (A und B) Langlöcher und Rundlöcher, welche nach dem Verfahren der Erfindung hergestellt wurden;
- Fig. 5: (A und B) Drähte mit Drahtdurchmessern von 0.13 mm und 0.076 mm zum Testen derzeitiger und zukünftiger Mehrschichtkeramikprodukte.

Typische Anwendungen des reaktiven Ionenätzens (RIE) bei Halbleiterprozessen ätzen einseitig in Tiefen von < etwa 6 µm. So können beispielsweise Subkollektorisolationen in Silicium von 4 bis 5 µm Tiefe hergestellt werden nach einem Verfahren, das in der Europäischen Patentschrift EP-B 0 111 086 beschrieben ist. Ein anderes Verfahren, welches einen Dreilagenphotoresistprozess in Kombination mit reaktivem Ionenätzen verwendet und zu 3 bis 4 µm tiefen Gräben im Siliciumhalbleitersubstrat führt, ist in der Europäischen Patentschrift 0 098 318 beschrieben. Ähnliche Tiefen werden auch geätzt bei Dünnfilmverdrahtungen der ersten Packungsebene zur Erzeugung sog. Abhebestrukturen in Polyimid.

Um senkrechte Strukturen durch Kunststoffplatten mit viel größeren Schichtdicken, d. h. Dicken von etwa 0.1 bis 2 mm, vorzugsweise von etwa 0.5 bis 1 mm, ätzen zu können, müssen eine Reihe wichtiger Anforderungen, die nachfolgend aufgeführt sind, erfüllt werden:
1. Hohe Ätzrate für das Substrat aus Polymermaterial;
2. Geringe Ätzrate für das Maskierungsmaterial;
3. Sehr gute Haftung des Photoresists auf dem Substrat;
4. Geringe Unterätzung der Photoresistmaske;
5. Planparallelität von Vorder- und Rückseite des Substrats und Lagetoleranz von Eintritts- und Austrittsöffnungen;
6. Vollständiges Strippen des Photoresists.

Zu 1: Die Ätzraten für einige Polymere, die im typischen RIE-Bereich bei Drucken von etwa 13 µbar geätzt werden, liegen bei etwa 0.1 bis 0.2 µm/Min. Mit diesen Ätzraten müßte man etwa 160 Stunden arbeiten, um eine etwa 1 mm dicke Kunststoffplatte durchätzen zu können, was sehr unwirtschaftlich ist.

Überraschenderweise wurde gefunden, daß Polyoxymethylene (POM) unter den o. g. RIE-Bedingungen eine etwa 10- bis 30mal höhere Ätzrate als einige der bekannten Polymeren aufweisen. Polyoxymethylenhomopolymerisate, welche durch Polymerisation von Formaldehyd und Endgruppenverschluß durch Acetylierung entstehen, weisen folgende Formel auf:

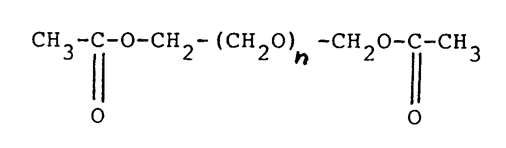

Polyoxymethylencopolymerisate entstehen durch Copolymerisation von Formaldehyd mit geringen Mengen eines Comonomeren, beispielsweise mit Ringethern oder cyclischen Formalen mit mindestens zwei benachbarten C-Atomen. Aufgrund ihrer thermischen Stabilität, ihrer geringen Feuchtigkeitsaufnahme und guten Gleitwirkung sind die Homo- wie auch die Copolymerisate zur Herstellung von Führungsplatten für feine Metalldrähte besonders geeignet. Homo- und Copolymerisate des Polyoxymethylens sind beispielsweise unter folgenden Handelsnamen erhältlich: Celcon (Copolymer), Celanese Corp.; Delrin (Homopolymer), Du Pont de Nemours; Hostaform (Copolymer), Hoechst/Celanese und Ultraform (Copolymer), BASF/Degussa.

Es ist derzeit nicht genau bekannt, wodurch die 10- bis 30mal höhere Ätzrate von POM bewirkt wird. Es wird angenommen, daß dies im wesentlichen auf eine starke Temperaturabhängigkeit der Ätzrate von POM während des RIE zurückzuführen ist. Bei anderen Polymermaterialien ist eine solche Abhängigkeit offenbar nicht vorhanden. RIE von POM wurde in einem Temperaturbereich von etwa 25 bis 140°C durchgeführt.

Zu 2: Masken, die zum reaktiven Ionenätzen von POM verwendet werden, sollten eine möglichst niedrige Ätzrate im Sauerstoffplasma aufweisen. Als Maskierungsmaterial bieten sich deshalb anorganische Materialien wie Siliciumoxinitrid SiNO an. SiNO hat im Sauerstoffplasma eine so niedrige Ätzrate, daß sich ein Ätzratenverhältnis von etwa 2000 : 1 erzielen läßt, d. h. mit einer Maske von nur etwa 0.5 µm Dicke hätte man eine 1 mm dicke POM-Platte durchätzen können. Da aber beide Materialien (SiNO und POM) thermische Ausdehnungskoeffizienten aufweisen, die sich um mehr als zwei Zehnerpotenzen unterscheiden und die POM-Scheiben beim Prozessieren mehrere Heizzyklen bis zu 100°C erfahren, kommt es zur Ausbildung von Mikrorissen in der SiNO-Schicht und einer schlechten Haftung von SiNO auf POM, so daß SiNO nicht als Maskierungsmaterial eingesetzt werden kann.

Es wurden daraufhin Versuche unternommen, die Probleme mit einem organischen Maskierungsmaterial zu lösen. Als solches wurde ein Positivphotoresist, beispielsweise AZ 1350 J der Firma Shipley, welcher aus einem PhenolFormaldehyd-Harz und 3,4-Dihydroxybenzophenon-4-[naphthochinon(1,2)diazid(2)] -sulfonat als reaktivem Bestandteil besteht, verwendet. Um die Widerstandsfähigkeit des Photoresistmaterials im Sauerstoffplasma während des RIE zu erhöhen, wird ersteres mit einer mehrfunktionellen organometallischen Verbindung behandelt, welche wenigstens 2 funktionelle Gruppen enthält oder liefern kann, die mit den entsprechenden reaktiven Gruppen des Polymerphotoresists zu reagieren vermögen. Eine Vielzahl von Verbindungen, die diese Bedingungen erfüllen, sind in der Europäischen Patentschrift EP-B 0 198 215 beschrieben. Bevorzugte Verbindungen sind cyclische Organosiliciumverbindungen, insbesondere Hexamethylcyclotrisilazan (HMCTS). HMCTS bewirkt eine Vernetzung der Oberfläche des Photoresistmaterials und damit dessen erhöhte Widerstandsfähigkeit im Sauerstoffplasma während des RIE. Die Photoresistmaske wird nach dem Entwickeln und einer Nachbelichtung mit HMCTS in der Dampfphase oder mit einer HMCTS-Lösung behandelt. Bevorzugte Lösungsmittel sind aromatische Kohlenwasserstoffe wie Benzol, Toluol, Xylol, Chlorbenzol und dergl. N-methyl-pyrrolidon, gamma-Butyrolacton, Acetate wie Butylacetat und Ether wie Tetrahydrofuran sind ebenfalls geeignet. Wegen der Schmelztemperaturen von POM von etwa 165 bis 168°C muß die Nachhärttemperatur des silylierten Photoresists auf etwa 90°C abgesenkt werden. Bei diesen Temperaturen ist gewährleistet, daß sich die POM-Scheiben nicht verbiegen.

Als Ergebnis dieses Prozesses wird ein Ätzratenverhältnis zwischen POM und dem silylierten Photoresist von etwa ≧ 200 : 1 erhalten, d. h. mit einer etwa 5 µm dicken Maske aus silyliertem Photoresist kann eine etwa 1 mm dicke Platte aus Polyoxymethylen durchgeätzt werden. Ein weiterer Vorteil dieses Prozesses ist, daß eine Zwischenschicht zwischen dem Photoresist und dem POM-Substrat entfallen kann.

Anstelle des zuvor genannten Positivphotoresists, dessen Widerstandsfähigkeit gegen ein sauerstoffhaltiges Plasma durch eine Silylierung erhöht werden muß, kann auch ein Photoresistmaterial verwendet werden, das von Haus aus gegen das RIE in einem sauerstoffhaltigen Plasma widerstandsfähig ist. Photoresistmaterialien, welche diese Eigenschaften aufweisen, sind beispielsweise Gegenstand der Europäischen Patentschrift 0 147 127. Die dort beschriebenen Materialien sind Reaktionsprodukte aus Polyorganosiliciumverbindungen und Chinondiaziden (z.B. Naphthochinon-diazopolysiloxan) und können sowohl als Positiv- wie auch als Negativresistmaterialien verwendet werden. Weitere, in dem Verfahren gemäß der Erfindung verwendbare Photoresistmaterialien auf Polysiloxanbasis sind in der Europäischen Patentschrift 0 199 940 beschrieben. Im Falle der Verwendung von Negativphotoresistmaterialien in dem Verfahren gemaß der Erfindung muß eine Maskenumkehr vorgenommen werden.

Zur Entwicklung der Photoresistmaterialien gemäß EP-B 0 147 127 ist entweder wässrige, 10 %ige KOH oder eine 10 %ige alkoholische Lösung von Tetramethylammoniumhydroxid geeignet. Bei Verwendung des Resists als Negativphotoresist werden die belichteten Photoresistschichten etwa 2 Minuten lang bei 80°C nachgehärtet und die nichtbelichteten Bereiche der Photoresistschichten anschließend mit einem organischen Lösungsmittel entfernt.

Zu 3: Ganz wesentlich für die Anwendung der Photoresistprozesse gemäß EP-B 0 198 215 oder EP-B 0 147 127 ist eine eigens dafür entwickelte Reinigung der POM-Oberfläche, welche die erforderliche Haftung des Photoresists gewährleistet. Zur Reinigung wird eine verdünnte Schwefelsäure in einem sehr engen Prozessfenster eingesetzt. Am vorteilhaftesten hat sich eine Konzentration von etwa 40 Vol% erwiesen, weil bei einer geringeren Konzentration die Haftverbesserung nicht ausreichend war und bei einer höheren die POM-Oberfläche angeätzt wurde.

Zu 4: Eine möglichst geringe Unterätzung der Photoresistmaske bewirkt, daß beim RIE im Substrat nahezu senkrechte Strukturen ohne eine Verbreiterung gegenüber der ursprünglichen Maskenöffnung erhalten werden. Bei Anwendungen in der Halbleitertechnologie (beispielsweise im Dreilagenresist-Prozess der EP 0 098 318), bei denen üblicherweise einige µm Photoresist mit vertikalen Wänden geätzt werden, ist die Unterätzung, d. h. das laterale Ätzen der Struktur in der Größenordnung von einigen Zehntel µm oder darunter. Bei einer Strukturtiefe von 2 µm und 0.1 µm Unterätzung beispielsweise hat man einen Anisotropiefaktor von 20 : 1. Bei demselben Anisotropiefaktor würde bei einer Strukturtiefe von 1 mm die Unterätzung etwa 50 µm betragen, d. h. der kleinste theoretische Lochdurchmesser wäre etwa 100 µm. Um, bei einer Strukturtiefe von 1 mm, Löcher mit noch kleineren Durchmessern ätzen können, muß die Unterätzung, die bei den o. angegebenen Halbleiteranwendungen auftritt, noch einmal reduziert werden. Ein typischer Wert für die Unterätzung bei einer Strukturtiefe von 1 mm liegt beispielsweise bei etwa 10 µm, was einem Anisotropiefaktor von 100 : 1 entspricht. Die Unterätzung kann durch entsprechende Einstellung der Parameter Druck und Gleichspannungs-Vorspannung, welche einen entscheidenden Einfluß auf dieselbe haben, reduziert werden.

Die Erwartung, daß bei niedrigeren Drucken die Unterätzung geringer wird, wurde durch Versuche bestätigt. Die besten Ergebnisse hinsichtlich der Unteräzung wurden bei einem Druck von etwa 0.8 bis 1 µbar erhalten. Eine Reduzierung des Drucks auf Werte < 0.8 µbar war nicht möglich. Bei sehr niedrigen Drucken muß auch eine geringere Ätzrate des zu ätzenden Substrats und aufgrund des Sputtereffekts eine erhöhte Ätzrate für die Maske in Kauf genommen werden.

Für das Verfahren gemäß der Erfindung hat sich ein Druckbereich von etwa 0.8 bis 15 µbar als besonders vorteilhaft im Hinblick auf die Unterätzung erwiesen. Die absolute Ätzrate für diesen Bereich liegt, in Abhängigkeit von der Temperatur, bei etwa 1 bis 3 µm pro Min. und das Ätzratenverhältnis bei etwa ≧ 200 : 1.

Die Gleichspannungs-Vorspannung, welche eine kapazitativ angekoppelte Kathode ausbildet, ist, vorausgesetzt daß das Plasmapotential verglichen mit dieser Spannung hinreichend gering ist und für einen gegebenen Druck bestimmend für die maximale kinetische Energie der auf das Substrat auftreffenden Ionen. Diese Spannung wird beispielsweise beeinflußt durch die angelegte HF-Amplitude, durch die Geometrie des Systems und durch die Wahl des Kathodenmaterials. Es hat sich gezeigt, daß eine möglichst hohe Gleichspannungs-Vorspannung Voraussetzung für einen guten Anisotropiefaktor ist. Spannungswerte von etwa 600 bis 900 V, welche in dem Verfahren gemäß der Erfindung bevorzugt angewendet werden, können durch eine Verkleinerung der aktiven Kathodenfläche relativ zur Anodenfläche erzielt werden.

Zu 5: Gemäß der Erfindung werden die mit Photoresist beschichtete POM-Substrate in einem Kontaktbelichtungsverfahren auf beiden Seiten gleichzeitig belichtet. Voraussetzung für eine Justage der zur gleichzeitigen Belichtung verwendeten Masken mit einer Genauigkeit von ± 1 bis 2 µm auf dem Substrat ist eine hohe Planparallelität von Vorder- und Rückseite der Substrate.

Durch die doppelseitige Lithographie kann auch eine hohe Lagetoleranz von Eintritts- und Austrittsöffnungen erzielt werden, d. h. Eintritts- und Austrittsöffnungen der Photoresistmasken liegen identisch übereinander. Das hat zur Folge, daß auch die Eintritts- und Austrittsöffnungen der fertig geätzten Strukturen identisch übereinanderliegen werden. In einem einseitigen Ätzverfahren bewirkt eine Abweichung von nur einem Grad, bezogen auf die einfallenden Ionen des RIE bei einer zu ätzenden Plattendicke von 1 mm, einen Versatz von etwa 17 µm. In einem sequentiellen Ätzverfahren von der Vorder- und dann von der Rückseite der Substrate halbiert sich praktisch dieser Versatz, wobei ein geringfügiger Versatz in den Lochmitten keine nachteiligen Auswirkungen auf die spätere Verwendung der Lochplatten hat.

Die zur Belichtung der Photoresistschichten auf Vorder-und Rückseite der Substrate verwendeten Masken werden mit einem Maskenausrichtgerät MA 25 der Fa. Süss, welches eine Justagegenauigkeit von etwa 1 bis 2 µm ermöglicht, zueinander justiert. Nach der gleichzeitigen Belichtung und Entwicklung und, bei Anwendung des Photoresistprozesses gemäß EP-B 0 198 215 der Nachbelichtung und Silylierung der Photoresistmasken, werden die Substrate sequentiell geätzt. Man ätzt von beiden Seiten eine Zeit, die etwa 2/3 der Substratdicke entspricht. Die Methode des zweiseitigen Ätzens mit jeweils etwa 10 bis 15 % Überätzung erlaubt es, qualitativ gute Durchführungsöffnungen zu erzeugen. Da die Geometrie der Muster mittels Photolithographie definiert wird, lassen sich nicht nur Rundlöcher, sondern Strukturen beliebiger Form ätzen.

Zu 6: Der silylierte Photoresist wird beim Beschuß mit Sauerstoff zum Teil in Siliciumdioxid umgewandelt. Daher treten beträchtliche Probleme bei Strippen der silylierten Photoresistreste auf. Versuche haben ergeben, daß mit etwa 44 Gew.%iger KOH bei etwa 70°C während einer Stunde der restliche Resist ohne Beschädigung des POM-Substrats gestrippt werden kann. Der Photoresist, der in der EP-B 0 147 127 beschrieben ist, läßt sich ebenfalls mit diesem Stripper entfernen.

Ausführungsbeispiel: Als Substrate werden Platten aus Polyoxymethylen, vorzugsweise aus Delrin (Warenzeichen der Du Pont de Nemours Comp.) vom 1 mm Dicke und 100 mm Durchmesser verwendet. Die Reinigung erfolgt in bekannte Weise durch Spülen mit DI-Wasser und Alkohol. Anschliessend werden die Substrate zur Verbesserung der Photoresisthaftung etwa 5 Min. lang mit etwa 40 Vol.%iger H₂SO₄ behandelt (s. Punkt 3). Alle Reinigungsstufen werden bei Zimmertemperatur durchgeführt.

Auf die gereinigten Substrate (1) (Fig. 1A) wird in bekannter Weise beidseitig eine Photoresistschicht (2) in einer Schichtdicke von etwa 5 bis 6 µm aufgesponnen. Als Photoresist wird der Positivphotoresist AZ 1350 J der Fa. Shipley verwendet. Die Photoresistschichten (2) werden anschließend etwa 15 Min. lang bei etwa 80°C gehärtet. Die beschichteten Substrate (1) (Fig. 1B) werden dann mit einem Belichtungsgerät MA 25 der Fa. Süss beidseitig bildmäßig mit UV Strahlung in einem Wellenlängenbereich von 200 bis 450 nm, vorzugsweise bei 365 nm belichtet (s. Punkt 5). Die belichteten Bereiche (3) werden durch Entwickeln mit dem Shipley AZ-Entwickler 321, einem alkalischen Entwickler auf der Basis von Natriumborat und Natriumhydroxid, welcher im Verhältnis 1 : 4 mit DI-Wasser verdünnt ist, entfernt. Eine ganzflächige Nachbelichtung mit UV-Strahlung in einem Wellenlängenbereich von 200 bis 450 nm, vorzugsweise bei 365 nm, verkürzt die Behandlungszeit der darauffolgenden Silylierung.

Zur Silylierung der Photoresistschichten (3) wird ein Bad folgender Zusammensetzung (in Vol. %) verwendet: 10 % Hexamethylcyclotrisilazan (HMCTS); 1 % N-methylpyrrolidon (NMP); 89 % Xylol. Die Proben werden etwa 90 Min. lang in diesem Bad bei einer Badtemperatur von etwa 40°C belassen. Nach der Silylierung werden die Proben mit Xylol gespült und etwa 5 Min. lang bei etwa 90°C gehärtet.

Das reaktive Ionenätzen in den freigelegten Bereichen der Maske, welches von der Vorder- und dann von der Rückseite des Substrats her erfolgt, wird in einem Sauerstoffplasma, welches gegebenenfalls bis zu 50 % Argon enthält; bei einem Gasfluß von 5 bis 100 sccm; in einem Druckbereich von 1 bis 50 µbar und bei einer Gleichspannungs-Vorspannung von etwa 200 bis 900 V vorgenommen für eine Zeit, bis die gewünschte Ätztiefe erreicht ist.

In dem speziellen Ausführungsbeispiel werden die Proben zum reaktiven Ionenätzen (Fig. 1C) unter den nachfolgenden Bedingungen in ein RIE-System (Leybold-Heraeus VZK 550 A) gegeben:
- Kathodenmaterial:: Polycarbonat, Makrolon (Warenzeichen der Bayer AG);
- Druck:: 10 µbar;
- Gasfluß:: 30 sccm Sauerstoff, 12 sccm Argon;
- HF-Amplitude:: 900 V;
- Gleichspannungs-Vorspannung:: 890 V;
- Substrattemperatur:: 80°C;
- Ätzrate:: 1.25 µm/Min.

Nach dem RIE der Durchführungsöffnungen (4) (Fig. 1C) muß in einem letzten Schritt der restliche Photoresist gestrippt werden. Hierzu wird eine etwa 44 Gew.%ige KOH bei etwa 70°C verwendet. Die Verweilzeit der Proben in dem Stripperbad liegt bei etwa 60 Minuten. Anschließend werden die mit den Durchführungsöffnungen versehenen Substrate in bekannter Weise in DI-Wasser und Alkohol gespült.

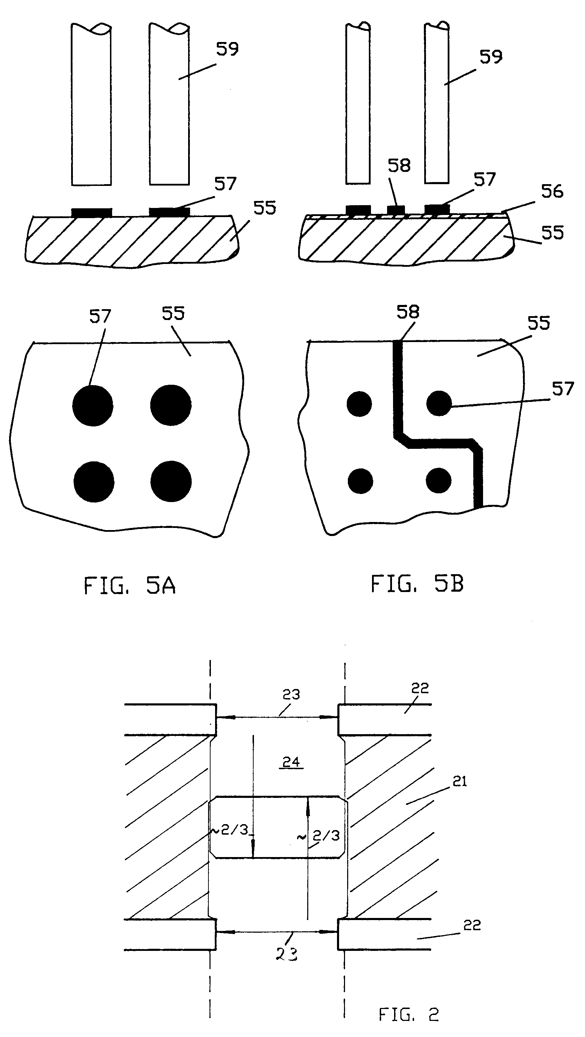

In Fig. 2 ist der Prozesschritt des Ätzens in einer Durchführungsöffnung (24) durch das Delrin-Substrat (21) vergrößert dargestellt. In den silylierten Photoresistmasken (22) auf Vorder- und Rückseite des Substrats (21) sind Maskenöffnungen (23) angeordnet. Die Durchführungsöffnung (24) wird durch RIE zuerst von der Vorderseite und dann, nach dem Wenden der Probe, von der Rückseite her jedesmal bis zu einer Tiefe von etwa 2/3 der Substratdicke in das Delrin-Substrat (21) geätzt. Durch die Überlappung der beiden Ätzzonen im mittleren Bereich der Durchführungsöffnung (24) ist es möglich, qualitativ hochwertige Durchführungsöffnungen zu erzeugen. Aus Fig. 2 ist auch die Unterätzung der Photoresistmaske (22) ersichtlich. Sie beträgt unter den oben angegebenen RIE-Bedingungen etwa 10 µm beiderseits unterhalb der Maskenöffnung (23).

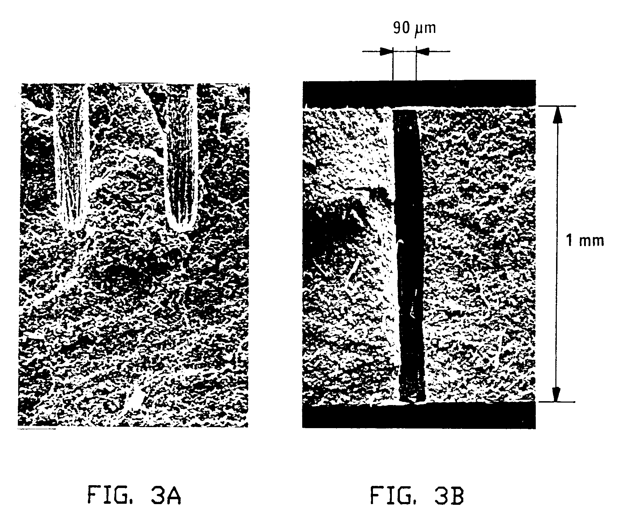

In den Fign. 3 A und B sind SEM-Aufnahmen von Löchern dargestellt, welche in Delrin-Platten geätzt wurden. Fig. 3 A zeigt ein Sackloch, und Fig. 3 B zeigt eine Durchführungsöffnung mit einem Durchmesser von 90 µm durch eine Delrin-Platte von 1 mm Dicke. Die Lochquerschnitte, welche eine große Uniformität über die gesamte Plattendicke aufweisen, wurden bei Einsatz der oben geschilderten, optimalen Prozessparameter erhalten.

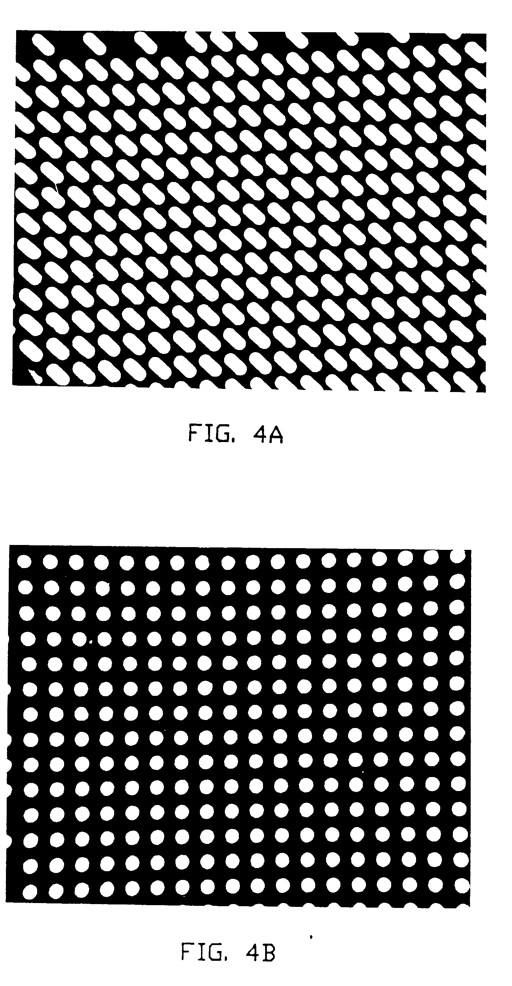

In den Fign. 4 A und B sind lichtoptische Aufnahmen von Durchführungsöffnungen in Transmission dargestellt, wobei in Fig. 4 A Langlöcher mit Abmessungen von etwa µm in der kurzen Achse und in Fig. 4 B Rundlöcher mit einem Durchmesser von etwa 100 µm dargestellt sind.

In Fig. 5 ist schematisch ein Verfahren zum Testen von Mehrschichtkeramiksubstraten dargestellt, wobei links die in den Testköpfen bisher verwendeten Drähte (59) mit Durchmessern von 0.13 mm und rechts Drähte mit Durchmessern von 0.76 mm, welche in zukünftigen Testköpfen Verwendung finden, dargestellt sind. Die Kontaktstellen (57) sind links auf einem Aluminiumoxidkeramiksubstrat (55) angeordnet, in der Abbildung rechts auf einer Polymerschicht (56), die sich wiederum auf einem Glaskeramiksubstrat (55) befindet. Zwischen den Kontaktstellen der Abbildung rechts sind zusätzlich Leiterzüge (58) angeordnet, welche in Dünnfilmtechnologie aufgebracht wurden. Aus den Draufsichten unter den jeweiligen Abbildungen ist die dichtere Anordnung der Kontaktstellen und Leiterzüge zukünftiger Produkte ersichtlich. In den bisher gemäß einem intonen Stand der Technik benutzten Testköpfen wurden die Drähte in der Regel durch drei Führungsplatten aus Delrin in großen Abständen geführt. In dem Drahtführungskonzept von Testköpfen für zukünftige Mehrschichtkeramiksubstrate werden die dünneren Drähte durch bis zu 30 aufeinander gestapelte Führungsplatten geführt. Testköpfe dieser Art sind in der Europäischen Patentschrift 0 283 545 (gleicher Anmeldetag wie vorliegende Anmeldung) beschrieben.

Mit dem Verfahren gemäß der Erfindung lassen sich Kunststoffplatten aus Polyoxymethylen mit einer Dicke von etwa 0.1 bis 2 mm, vorzugsweise von etwa 0.5 bis 1 mm, mit senkrechten Durchführungsöffnungen versehen. Die Durchführungsöffnungen können jede beliebige Form aufweisen.

Mit dem Verfahren gemäß der Erfindung, welches eine Kombination von Photolithographie und reaktivem Ionenätzen darstellt, können auch Bauteile aus Kunststoff mit Dimensionen < 100 µm hergestellt werden. Die genannten Verfahrensschritte ersetzen mechanische Bearbeitungsvorgänge wie Bohren, Drehen, Fräsen, Schneiden und dergl. im Zuge der Herstellung dieser Bauteile.

## Patentansprüche

1. Verfahren zum Herstellen beliebig geformter mikromechanischer Bauteile aus planparallelen Platten aus Polymermaterial oder beliebig geformter Durchführungsöffnungen in denselben, welches folgende Verfahrensschritte umfaßt:
A Herstellen einer Maske, indem
a) auf ein Substrat (1) aus Polymermaterial, welches Homo- oder Copolymerisate von Polyoxymethylen (POM) umfaßt, beidseitig eine Schicht (2) aus einem Photoresist in einer Dicke von etwa 2 bis 10 µm aufgetragen wird;
b) das gewünschte Muster gleichzeitig durch bildmäßiges Belichten der Photoresistschichten (2) auf der Vorder- und Rückseite erzeugt wird, wobei die Masken für die Belichtung auf etwa ± 1 bis 2 µm Genauigkeit zueinander justiert werden;
c) die Photoresistschichten (2) entwickelt und gegebenenfalls nachgehärtet werden;
B Herstellen der Bauteile oder der Durchführungsöffnungen durch reaktives Ionenätzen (RIE) in das Substrat (1), welches Homo- oder Copolymerisate von Polyoxymethylen (POM) umfaßt, von der Vorder- und dann von der Rückseite her, jedesmal bis zu einer Tiefe von etwa 2/3 der Substratdicke, mit einem Sauerstoffplasma in einem Druckbereich von 1 bis 50 µbar und
C Strippen der Photoresistmasken von der Vorder- und Rückseite des Substrats (1).

2. Verfahren nach Anspruch 1, dadurch gekennzeichnet, daß die Substrate eine Dicke von etwa 0.1 bis 2 mm, vorzugsweise von etwa 0.5 bis 1 mm, aufweisen.

3. Verfahren nach Anspruch 1, dadurch gekennzeichnet, daß zur Verbesserung der Haftung des Photoresists auf den Oberflächen der Substrate (1) diese mit etwa 40 Vol%iger Schwefelsäure behandelt werden.

4. Verfahren nach Anspruch 1, dadurch gekennzeichnet, daß als Photoresist ein Phenol-Formaldehyd-Harz mit einem 3,4-Dihydroxybenzophenon-4-[naphthochinon(1,2)diazid(2)]-sulfonat als reaktivem Bestandeil aufgetragen und etwa 15 Minuten lang bei 80°C nachgehärtet wird.

5. Verfahren nach Anspruch 1, dadurch gekennzeichnet, daß als Photoresist ein Naphthochinon-diazopolysiloxan verwendet wird.

6. Verfahren nach den Ansprüchen 1, 4 und 5, dadurch gekennzeichnet, daß die bildmäßige Belichtung der Photoresistschichten (2) mit UV-Strahlung in einem Wellenlängenbereich von 200 bis 450 nm vorgenommen wird.

7. Verfahren nach den Ansprüchen 1 und 4, dadurch gekennzeichnet, daß die belichteten Photoresistschichten in einem 1 : 4 mit DI-Wasser verdünnten Entwickler auf der Basis von Natriumborat und Natriumhydroxid entwickelt und anschließend ganzflächig mit UV-Licht in einem Wellenlängenbereich von 200 bis 450 nm bestrahlt werden.

8. Verfahren nach den Ansprüchen 1, 4, 6 und 7, dadurch gekennzeichnet, daß die Photoresiststrukturen nach Entwicklung und Belichtung zur Erhöhung ihrer Widerstandsfähigkeit im Sauerstoffplasma während des RIE mit einer cyclischen Organosiliciumverbindung behandelt und nachgehärtet werden.

9. Verfahren nach Anspruch 8, dadurch gekennzeichnet, daß die Photoresiststrukturen mit einer Lösung von Hexamethylcyclotrisilazan in Xylol etwa 90 Min. lang bei 40°C behandelt und anschließend etwa 5 Min. lang bei 90°C nachgehärtet werden.

10. Verfahren nach Anspruch 5, dadurch gekennzeichnet, daß die belichteten Photoresistschichten mit einer 10 %igen wässrigen KOH oder einer 10 %igen Lösung von Tetramethylammoniumhydroxid in Alkohol entwickelt werden.

11. Verfahren nach Anspruch 5, dadurch gekennzeichnet, daß die belichteten Photoresistschichten etwa 2 Min. lang bei 80°C nachgehärtet und anschließend die nichtbelichteten Bereiche der Photoresistschichten mit einem organischen Lösungsmittel entfernt werden.

12. Verfahren nach Anspruch 1, dadurch gekennzeichnet, daß das reaktive Ionenätzen in den freigelegten Bereichen der Maske, zuerst von der Vorder- und dann von der Rückseite des Substrats aus Homo- oder Copolymerisaten von Polyoxymethylen (POM), mit einem Sauerstoffplasma, gegebenenfalls mit einem Anteil von bis zu 50 % Argon; bei einem Gasfluß von 5 bis 100 sccm; in einem Druckbereich von 1 bis 50 µbar und bei einer Gleichspannungs-Vorspannung von etwa 200 bis 900 V für eine Zeit, bis die gewünschte Ätztiefe erreicht ist, vorgenommen wird.

13. Verfahren nach den Ansprüchen 5, 8 und 9, dadurch gekennzeichnet, daß die siliciumhaltigen Photoresistmasken nach dem RIE in einem Stripperbad aus etwa 44 %iger KOH bei einer Verweilzeit im Bad von etwa 60 Min. und einer Badtemperatur von etwa 70°C gestrippt werden.

14. Verfahren gemäß den Patentansprüchen 1 bis 13, dadurch gekennzeichnet, daß die planparallelen Platten aus Polyoxymethylenhomo- oder Copolymerisaten mit beliebig geformten Durchführungsöffnungen, gestapelt werden, um Kontaktierungsdrähte in Testköpfen zum Testen von Mehrschichtkeramikprodukten zuführen.

## Claims

1. Process for fabricating arbitrarily shaped micro-mechanical components from plane-parallel plates of polymer material or arbitrarily shaped through holes in same, comprising the steps of
A. producing a mask by
a) applying to either side of a substrate (1) of polymer material, containing homo- or copolymers of polyoxymethylene (POM), a photoresist layer (2) of about 2 to 10 µm thickness;
b) simultaneously generating the desired pattern by imagewise exposure on the front and the back side of the photoresist layers (2), the masks for exposure being aligned to each other with an accuracy of about ± 1 to 2 µm;
c) developing and, if necessary, postbaking the photoresist layers (2);
B. fabricating the components or the through holes by reactive ion etching (RIE) in the substrate (1), containing homo- or copolymers of polyoxymethylene (POM), first from the front and then from the back side, each time down to a depth of about 2/3 of the substrate thickness, using an oxygen plasma at a pressure ranging from 1 to 50 µbar, and
C. stripping the photoresist masks from the front and the back side of the substrate (1).

2. Process as claimed in claim 1,
characterized in that the substrates have a thickness of about 0.1 to 2 mm, preferably of 0.5 to 1 mm.

3. Process as claimed in claim 1,
characterized in that for improving the adhesion of the photoresist to the surfaces of the substrates (1), these are treated with about 40 percent by volume sulphuric acid.

4. Process as claimed in claim 1,
characterized in that a phenolformaldehyde resin with a 3,4-dihydroxybenzophenone-4-[naphtho-quinone(1,2)diazide(2)]-sulfonate as reactive constituent is applied as photoresist and post-baked for about 15 minutes at 80° C.

5. Process as claimed in claim 1,
characterized in that a naphthoquinone-diazopolysiloxane is used as photoresist.

6. Process as claimed in claims 1, 4 and 5,
characterized in that imagewise exposure of the photoresist layers (2) with UV radiation is effected in a wavelength range of 200 to 450 nm.

7. Process as claimed in claims 1 and 4,
characterized in that the exposed photoresist layers are developed in a 1 : 4 DI water diluted sodium borate and sodium hydroxide based developer and subsequently blanket irradiated with UV-light in a wavelength range of 200 to 450 nm.

8. Process as claimed in claims 1, 4, 6, and 7,
characterized in that the photoresist structures, after development and exposure, are treated with a cyclic organosilicon compound and postbaked to increase their resistance in oxygen plasma during RIE.

9. Process as claimed in claim 8,
characterized in that the photoresist structures are treated with a solution of hexamethylcyclotrisilazane in xylene for about 90 minutes at 40° C and then postbaked for about 5 minutes at 90° C.

10. Process as claimed in claim 5,
characterized in that the exposed photoresist layers are developed with 10 percent aqueous KOH or a 10 percent solution of tetramethylammoniumhydroxide in alcohol.

11. Process as claimed in claim 5,
characterized in that the exposed photoresist layers are postbaked for about 2 minutes at 80° C and the non-exposed regions of the photoresist layers are subsequently removed with an organic solvent.

12. Process as claimed in claim 1,
characterized in that the reactive ion etching in the bared regions of the mask is effected first from the front and then from the back side of the substrate of homo- or copolymers of polyoxymethylene (POM) in an oxygen plasma, if necessary, with a quantity of up to 50 percent argon, using a gas flow of 5 to 100 sccm, a pressure range of 1 to 50 µbar and a DC self-bias potential of about 200 to 900 V until the desired etch depth has been obtained.

13. Process as claimed in claims 5, 8 and 9,
characterized in that the silicon-containing photoresist masks are stripped in a stripper bath of about 44 percent KOH, while remaining in the bath for about 50 minutes at a bath temperature of about 70° C.

14. Process as claim in claims 1 to 13,
characterized in that the plane-parallel plates of polyoxymethylene homo- or copolymers with arbitrarily shaped through holes are stacked for linking contact wires in test heads for testing multilayer ceramic products.

## Revendications

1. Procédé de fabrication de composants micromécaniques de forme quelconque à partir de plaques à surfaces planes parallèles en matériau polymère ou d'ouvertures de passage de forme quelconque ménagées dans celles-ci, lequel comprend les étapes de procédé suivantes :
A - fabrication d'un masque selon lequel :
(a) on applique des deux côtés d'un substrat (1) en matériau polymère, constitué d'un homo- ou copolymérisat de polyoxyméthylène (POM), une couche (2) photosensible selon une épaisseur de 2 à 10 µm environ,
(b) on réalise le modèle souhaité par un éclairement modéré d'image des couches photosensibles (2) sur les faces avant et arrière, les masques utilisés pour l'éclairement étant ajustés avec une précision d'environ ± 1 à 2 µm l'un par rapport à l'autre,
(c) on développe les couches photosensibles (2) et on les durcit ensuite le cas échéant,
B - fabrication des composants ou des ouvertures par attaque ionique réactive (RIE) dans le substrat (1), constitué d'un homo- ou copolymérisat de polyoxyméthylène (POM), au niveau de la face avant puis de la face arrière, jusqu'à une épaisseur à chaque fois d'environ les 2/3 de l'épaisseur du substrat, avec un plasma d'oxygène dans un intervalle de pression de 10⁵ à 50.10⁵ µPa et,
C - application des masques photosensibles sur les faces avant et arrière du substrat (1).

2. Procédé selon la revendication 1, caractérisé en ce que les substrats ont une épaisseur d'environ 0,1 à 2 mm, avantageusement de 0,5 à 1 mm.

3. Procédé selon la revendication 1, caractérisé en ce qu'on traite les substrats (1) avec une solution d'acide sulfurique à 40 % en volume pour améliorer l'adhésion de la couche photosensible sur les surfaces dudit substrat.

4. Procédé selon la revendication 1, caractérisé en ce qu'on utilise à titre de couche photosensible le 3,4-dihydroxybenzophénon-4-[naphtoquinone-(1,2)-diazide-(2)]-sulfonate comme constituant réactif, et on durcit ensuite pendant 15 minutes à 80°C.

5. Procédé selon la revendication 1, caractérisé en ce qu'on utilise comme couche photorésistante un naphtoquinone-diazopolysiloxane.

6. Procédé selon les revendications 1, 4 et 5, caractérisé en ce que l'éclairement modéré d'image des couches photosensibles (2) est réalisé avec un rayonnement UV dans un domaine de longueur d'onde de 200 à 450 nm.

7. Procédé selon l'une des revendications 1 et 4, caractérisé en ce qu'on développe les couches photosensibles éclairées à l'aide d'un composé de développement dilué 1 : 4 avec l'eau distrillée ou la base du borate de sodium et de l'hydroxyde de sodium, puis on éclaire ensuite toute la surface avec une lumière UV dans un domaine de longueur d'onde allant de 200 à 450 nm.

8. Procédé selon les revendications 1, 4, 6 et 7, caractérisé en ce que traite durant l'attaque ionique (RIE) les structures photosensibles, après développement et éclairement pour augmenter leur résistance dans le plasma d'oxygène, avec un composé organosilicique cyclique et qu'on durcit ensuite.

9. Procédé selon la revendication 8, caractérisé en ce que les structures photosensibles sont traitées avec une solution d'hexaméthylcyclotrisilane dans le xylène pendant 90 minutes à une température de 40°C, puis durcies pendant 5 minutes à 90°C.

10. Procédé selon la revendication 5, caractérisé en ce que les couches photosensibles éclairées sont développées avec une solution aqueuse de KOH à 10 % ou une solution d'hydroxyde de tétraméthylammonium à 10 % dans l'alcool.

11. Procédé selon la revendication 5, caractérisé en ce que les couches photosensibles éclairées sont durcies pendant environ 2 minutes à 80°C et qu'on élimine ensuite les parties non-éclairées des couches photosensibles avec un solvant organique.

12. Procédé selon la revendication 1, caractérisé en ce qu'on réalise l'attaque ionique réactive au niveau des régions libres des masques d'abord au niveau de la face avant puis de la face arrière du substrat d'homo- ou copolymérisat de polyoxyméthylène (POM) avec un plasma à oxygène, le cas échéant avec une fraction d'argon jusqu'à 50 %, avec un débit gazeux de 5 à 100 sccm, dans un intervalle de pression de 10⁵ 50.10⁵ µPa et à une tension continue d'environ 200 à 900 V pendant un temps allant jusqu'à la profondeur d'attaque désirée.

13. Procédé selon les revendications 5, 8 et 9, caractérisé en ce que les masques photosensibles renfermant du silicium sont trempés après l'attaque ionique dans un bain de trempage de KOH à 44 % environ pendant un temps de trempage dans le bain d'environ 60 minutes et avec une température du bain d'environ 70°C.

14. Procédé selon les revendications 1 à 13, caractérisé en ce que les plaques en homopolymérisats ou en copolymérisats de polyoxyméthylène à faces planes, comportant des orifices traversants de formes quelconques, sont empilées pour introduire des fils de contact dans des têtes de test pour tester des produits en céramique stratifiés.
